# EUROPEAN PATENT APPLICATION

(11) **EP 4 756 665 A1**
(43) Date of publication of application: **10.06.2026**
(21) Application number: 25219209.1
(22) Date of filing: 27.11.2025
(51) Int. Cl.: G06F 30/27, G06F 30/3323

(54) **TEMPORAL LOGIC AUTOMATONS FOR LLM FACILITATED FORMAL VERIFICATION SCALABILITY ASSURANCE**

(30) Priority: 09.12.2024 US 202418974580
(71) Applicant: RTX Corporation, Farmington, CT 06032 (US)
(72) Inventor: MOULIN, Mark, Manchester, CT (US); BHATIA, Amit, Albany, CA (US)
(74) Representative: Dehns

(57) **Abstract**

An apparatus for performing formal verification of a system design comprises a first large language model (LLM) system configured to receive a natural language specification of the system design and generate a first description of the system design in a temporal logic language. A second LLM system is configured to receive the natural language specification of the system design and generate a second description of the system design in the temporal logic language. A generator and compiler is configured to generate finite state machines. At least one finite state machine (FSM) generated by the generator and compiler is configured to analyze operation of the system design using each of the at least one FSM including optimization properties. A formal verification (FV) tool is configured to determine whether the system design passes or fails responsive to the first description of the system design in the temporal logic language.

## Description

### TECHNICAL FIELD

This disclosure relates generally to system testing and verification for finite state machines designs. More specifically, this disclosure relates to the use of large language models and formal verification for system testing and verification for finite state machines designs.

### BACKGROUND

Formal verification (FV) model checking technology consists of a systematically exhaustive exploration state space of the mathematical finite model of non-deterministic finite-state machines. The FV tool generic structure consist of an extraordinarily complex tool chain processing. A large language model (LLM) is a type of AI program that can recognize, use and generate a grammar text. The ability to facilitate FV tool chain processing with LLM for the automate construction of FV tool chain artifacts would greatly benefit the testing of hardware system designs.

### SUMMARY

This disclosure relates to large language model facilitated formal verification.

In some examples, an apparatus for performing formal verification of a system includes a first large language model (LLM) system configured to receive a natural language specification of the system design and generate a first description of the system design in a temporal logic language responsive to the natural language specification of the system design. The apparatus also includes a second LLM system configured to receive the natural language specification of the system design and generate a second description of the system design in the temporal logic language responsive at least in part to the natural language specification of the system design. The apparatus also includes a generator and compiler implemented within the second LLM system configured to generate finite state machines responsive to the second description of the system design in the temporal logic language, where the generated finite state machines each include a plurality of optimization properties, the optimization properties including property reduction, property decomposition, system decomposition, constant propagation and under approximation. The apparatus also includes at least one finite state machine (FSM) generated by the generator and compiler configured to analyze operation of the system design using each of the at least one FSM including optimization properties, the optimization properties including property reduction, property decomposition, system decomposition, constant propagation and under approximation. The apparatus also includes a formal verification (FV) tool configured to determine whether the system design passes or fails responsive to the first description of the system design in the temporal logic language.

Any single one or any combination of the following features may be used with the examples above. The temporal logic language may include standard property specification language (PSL). The first LLM and the second LLM are further configured to generate at least one PSL next_event operator responsive to the natural language specification of the system design. The property decomposition breaks down a complex property into sub-properties. The system decomposition decomposes a complex system into smaller, interconnected components and analyzing the smaller, interconnected components separately. The constant propagation restricts an FV driver sum signal to a constant value. The under approximation sets an input value to an FV driver to a constant value for a rest of a run. The property reduction reduces a complex property to a simpler one preserving its essential meaning. The at least one FSM further may include a first finite state machine (FSM) generated by the generator and compiler configured to generate verification properties for the system design responsive to the first description of the system design in the temporal logic language, and a second FSM generated by the generator and compiler configured to generate verification drivers for the system design responsive to the first description of the system design in the temporal logic language and the verification properties for the system design.

In other examples, a method performs formal verification of a system design. The method also includes receiving a natural language specification of the system design at a first large language model (LLM) system, generating a first description of the system design in a temporal logic language responsive to the natural language specification of the system design using the first LLM system, receiving the natural language specification of the system design at a second LLM system, generating a second description of the system design in the temporal logic language responsive at least in part to the natural language specification of the system design using the second LLM system, generating finite state machines responsive to the second description of the system design in the temporal logic language using a generator and compiler implemented within the second LLM system, where the finite state machines each include a plurality of optimization properties, the optimization properties including property reduction, property decomposition, system decomposition, constant propagation and under approximation, analyzing operation of the system design using at least one finite state machine (FSM) generated by the generator and compiler and determining whether the system design passes or fails responsive to the first description of the system design in the temporal logic language responsive to the analysis of the operation of the system design using the at least one FSM using a formal verification (FV) tool.

Any single one or any combination of the following features may be used with the examples above. The step of generating further may include generating the first description of the system design and the second description of the system design in standard property specification language (PSL). The steps of generating further may include generating at least one PSL next_event operator responsive to the natural language specification of the system design. The step of generating the finite state machines further may include generating a finite state machine having a optimization characteristic of the property decomposition that breaks down a complex property into sub-properties. The step of generating the finite state machines further may include generating a finite state machine having a optimization characteristic of the system decomposition decomposes a complex system into smaller, interconnected components and analyzing the smaller, interconnected components separately. The step of generating the finite state machines further may include generating a finite state machine having a optimization characteristic of the constant propagation restricts an FV driver sum signal to a constant value. The step of generating the finite state machines further may include generating a finite state machine having a optimization characteristic of the under approximation sets an input value to an FV driver to a constant value for a rest of a run. The step of generating the finite state machines further may include generating a finite state machine having a optimization characteristic of the property reduction reduces a complex property to a simpler one preserving its essential meaning. The at least one FSM further may include generating verification properties for the system design responsive to the first description of the system design in the temporal logic language using a first finite state machine (FSM) generated by the generator and compiler and generating verification drivers for the system design responsive to the first description of the system design in the temporal logic language and the verification properties for the system design using a second FSM generated by the generator and compiler.

In still other examples, an apparatus performs formal verification of a system design. The apparatus also includes a first large language model (LLM) system configured to receive a natural language specification of the system design and generate a first description of the system design in a standard property specification language (PSL) responsive to the natural language specification of the system design, a second LLM system configured to receive the natural language specification of the system design and generate a second description of the system design in the PSL responsive at least in part to the natural language specification of the system design, a generator and compiler implemented within the second LLM system configured to generate finite state machines responsive to the second description of the system design in the second description of the system design in the PSL, where the generated finite state machines each include a plurality of optimization properties, the optimization properties including property reduction, property decomposition, system decomposition, constant propagation and under approximation, a first finite state machine (FSM) including optimization properties generated by the generator and compiler configured to generate verification properties for the system design responsive to the first description of the system design in the PSL, a second FSM including optimization properties generated by the generator and compiler configured to generate verification drivers for the system design responsive to the first description of the system design in the PSL and the verification properties for the system design, where the optimization properties for the first FSM and the second FSM include property reduction, property decomposition, system decomposition, constant propagation and under approximation, and a formal verification (FV) tool configured to determine whether the system design passes or fails responsive to the first description of the system design in the PSL.

Any single one or any combination of the following features may be used with the examples above. The property decomposition breaks down a complex property into sub-properties, where the system decomposition decomposes a complex system into smaller, interconnected components and analyzing the smaller, interconnected components separately, where the constant propagation restricts an FV driver sum signal to a constant value, where the under approximation sets an input value to an FV driver to a constant value for a rest of a run and where the property reduction reduces a complex property to a simpler one preserving its essential meaning.

Other technical features may be readily apparent to one skilled in the art from the following figures, descriptions, and claims.

### BRIEF DESCRIPTION OF THE DRAWINGS

For a more complete understanding of this disclosure and its advantages, reference is now made to the following description taken in conjunction with the accompanying drawings, in which like reference numerals represent like parts:
FIGURE 1 illustrates a block diagram of a structure of a formal verification;
FIGURE 2 illustrates a block diagram of a large language model implemented in conjunction with formal verification to provide for AI driver formal verification;
FIGURE 3 illustrates a flow diagram of a process for implementing formal verification with a large language model;
FIGURE 4 illustrates the operation of the large language model contextual finite state machine generator and compiler;
FIGURE 5 illustrates a flow diagram of the operation of the finite state machine generator and compiler;
FIGURE 6 illustrates a flow diagram of a construction of a finite state machine by the generator and compiler;
FIGURE 7 illustrates the quality of optimization implementations measured by a verification coverage estimation flow;
FIGURE 8 illustrates a next_event triangulation mesh;
FIGURE 9 illustrates a large language model formal verification coverage estimation flow;
FIGURE 10A illustrates a flow diagram of a process for implementing a finite element method;
FIGURE 10B illustrates a flow diagram of next_event granularity operations on a next_event structure;
FIGURE 11 illustrates witness and counter example generation by a model checking algorithm; and
FIGURE 12 illustrates a flow diagram of witness generation by a large language model.

### DETAILED DESCRIPTION

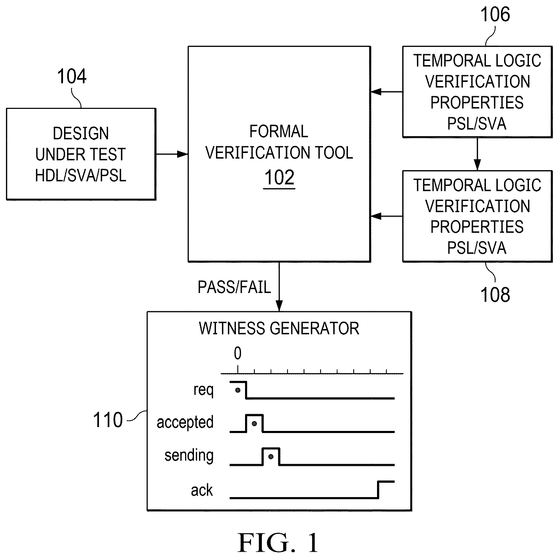

FIGURES 1 through 12, described below, and the various embodiments used to describe the principles of the present disclosure are by way of illustration only and should not be construed in any way to limit the scope of this disclosure. Those skilled in the art will understand that the principles of the present disclosure may be implemented in any type of suitably arranged device or system.

FIGURE 1 illustrates a block diagram of a typical structure of a formal verification (FV) tool 102. An FV tool 102 provides for the proving or disproving of the correctness of a non-deterministic finite-state machine (FSM) using formal methods of mathematics with respect to a certain formal specification or property expressed in temporal logic. Formal verification attempts to prove mathematically that certain formal requirements are met, and certain undesired behaviors cannot occur within the FSM. FV model checking technology systematically explores the state space of the mathematical finite model. The properties of the model to be verified are described in temporal logics. The technology consists of exploring all states and transitions in the model by using smart and domain specific abstraction techniques to consider the whole group of states in a single operation and reduce computing time.

An FSM also known as a finite automaton is a mathematical model of computation. The FSM can change from one state to another state in response to inputs. The change from one state to another state is called a transition period. An FSM is defined by a set of states, its initial state and the inputs that trigger each transition between states. Temporal logic is any system of rules and symbolisms for representing and reasoning about proposition qualified terms of time useful for verifying properties of a design that manifest themselves after a specific condition or state is reached. The temporal logic can describe the ordering of events in time without introducing time explicitly. Examples of temporal logic specification and verification languages include IEEE 1800 standard system Verilog (SVA) and IEEE 1850 standard property specification language (PSL) but other temporal logic specification and verification languages may be used.

The FV tool 102, as example for hardware verification, has a number of inputs for the verification operation. These include the design under test 104, the FV design properties/assertions 106 and the FV verification drivers 108. The design under test 104 can be in Verilog, HDL, SVA (IEEE 1800 standard System Verilog) or PSL (IEEE 1850 standard Property Specification Language) format. The property/assertions 106 as well as the temporal logic verification drivers 108 can also be in PSL or SVA format. Within the FV tool 102, the front end performs SVA/PSL/HDL parsing. The back end of the FV tool 102 performs FV environment compilation into an RTL logical circuit. The RTL logical circuit is flattened into AND/OR/NAND/NOT gate circuits. This model must then be checked. The verification engines within the FV tool 102 and uses BDD (binary decision diagram) data structures to represent a Boolean function. Bounded model checking uses SAT which is an efficient bug hunting tool. The FV tool 102 also includes a witness generator 110 for generating a witness comprising a sequence of input values that satisfies/fail the assertion of the model.

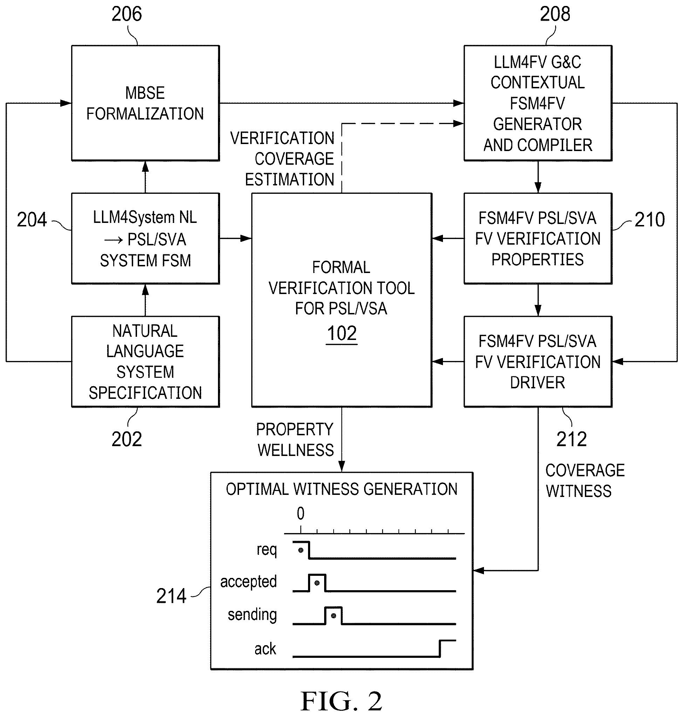

Referring now to FIGURE 2, there is illustrated the manner in which a large language model (LLM) can be implemented in conjunction with formal verification (FV) 102 to provide for AI driven formal verification that transforms traditional system testing such as that illustrated with respect to FIGURE 1 into a highly automated, efficient and cutting-edge process which improves speed and efficiency. The FV tool 102 has generic structures that provide extraordinarily complex tool chain processing coded in SVA and/or PSL system design, system properties and FV drivers that define a set of finite state machine for all inputs. The process would provide integration that seamlessly extracts product requirements from the design under test 104.

The LLM is used to autonomously create detailed verification environments and scenarios based upon the provided product definitions of the design under test 104. The LLM can automatically construct FV system properties from PSL/SVA specifications and construct an optimize FV driver into synthesizable PSL/SVA. This can be achieved using PSL next_ event operators that provides a very functional PSL construction which describes system behavior through logical formula. The PSL next_event operators can be reduced to other PSL operators and can also be nested. Specification requirement representations with temporal next_event operators fit the task of LLM construction of a complete set of temporal properties for each of the system input/outputs and states. SVA may also be used. While SVA doesn't have the next_event operator in its IEEE standard, it can be constructed as FSM from more simple SVA operators. The LLM system efficiently executes these tests with real-time feedback and dynamically adapts to meet testing demands. The LLM techniques automatically revise and refine verification scenarios and script them to improve future verification accuracy and efficiency in response to detected failures.

A natural language system specification 202 is created to define the characteristics of the hardware system (for example, a cyber physical system) that is being tested. The natural language system specification 202 is provided to a first LLM system, LLM4SYSTEM 204, that converts the natural language specification into a PSL/SVA format that is provided to the FV tool 102. The natural language system specification 202 is also provided to a model based system engineering (MBSE) formalization block 206. The output from the MBSE formalization block 206 is provided to a second LLM, LLM4FV 208 Generator and Compiler (G&C). The LLM4FV 208 provides inputs to the FSM verification properties 210 to automatically construct FV system properties from PSL/SVA specifications and FSM verification drivers 212 to construct and optimize an FV driver into synthesizable PSL/SVA. The FV verification properties 210 provide verification properties to the FV tool 102 as does the FV verification driver 212. The FV tool 102 generates property witnesses while the FV verification driver 212 generates coverage witnesses that are used for the generation of optical witnesses 214. The LLM4SYSTEM 204 and LLM4FV C&G (compiler and generator) 208 help to reduce manual workflows in the FV process.

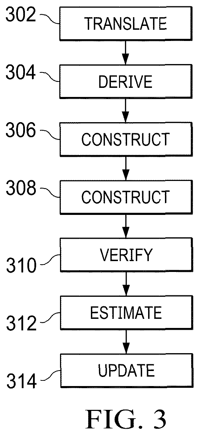

As discussed previously, a large language model (LLM) is an artificial intelligence program that can recognize, use and generate grammar text. An LLM is trained on huge sets of data and built on a machine learning type of neural network called a transformer model. The LLM4SYSTEM 204 and LLM4FV 208 automates the FV process by translating a natural language system specification 202 into PSL/SVA next_event description. With respect to the LLM4FV 208 as shown in FIGURE 3, the LLM 208 translates at 302 the natural language into a PSL next_event description. LLM system event sequences are derived at 304 from NL/PSL specifications. Several finite property FSMs are constructed at 306 with the LLM at the properties folding system event sequences. Finite driver FSMs are constructed with the LLM FV driver folding system event sequences. The PSL/SVA specification properties 210 and FSM drivers 212 are verified at 310 with the FV tool 102. An estimate for system verification coverage is made by the FV tool 102 at 312, and the FSM drivers 212 and FSM verification properties 210 are updated, if necessary.

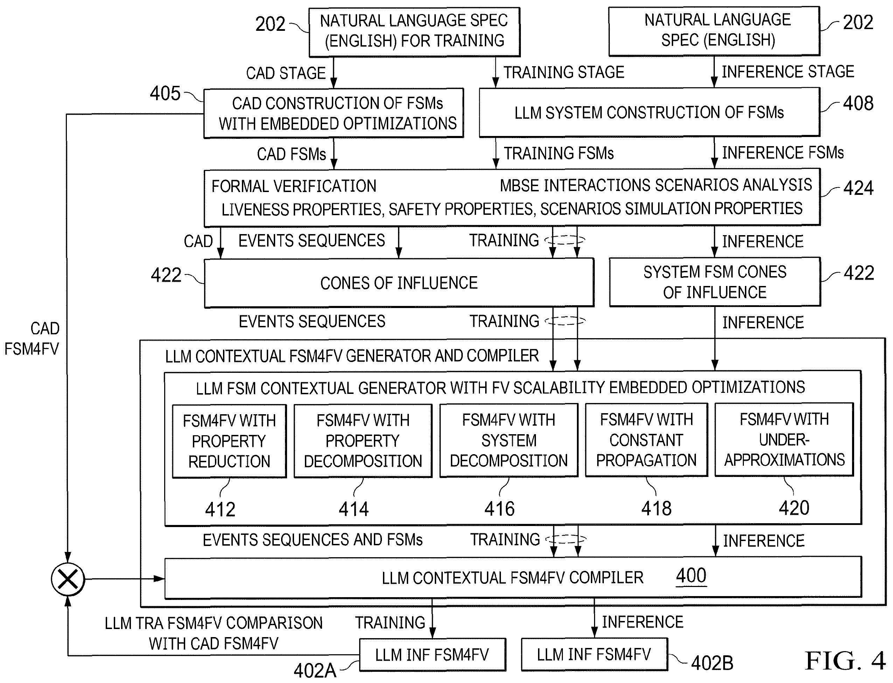

Referring now to FIGURE 4, there is illustrated the operation of the LLM contextual FSM generator and compiler 400 for generation of the FSM4FV 402 by the LLM4FV 208. The LLM contextual FSM generator and compiler 400 solves the FV properties and FV driver manual construction problem. The system uses a dual LLM architecture based on a human verification engineer training perspective stage 404 where a verification engineer manually constructs system properties from a natural language system specification 202 and communications with a system architect and designer. For the interference stage 406, a system LLM 408 creates system FSM 410 using next_event operators. In a training stage 404, the FSM4FV 402 has embedded verification scalability optimizations created using CAD tools 405. The LLM contextual FSM4FV generator and compiler 400 will generate FSM4FV 202 including input states training optimizations machines subject to verification scalability optimizations such as property reduction 412, property decomposition 414, system decomposition 416, constant propagation 418 and under approximations 420. The property reduction 412 reduces a complex property to a simpler one preserving its essential meaning. The property decomposition 414 breaks down a complex property into sub-properties. The system decomposition 416 decomposes a complex system into smaller interconnected components that are analyzed separately. Constant propagation 418 restricts some of the FV driver signals to a constant value. The under approximations 420 choose in the FV driver to set an input to a constant value for the rest of the run, although this compromises on coverage.

These constructed FSMs are unfolded into temporal cones of influence applying MBSE tools or FV on system temporal properties. Next in training stage 404 LLM4FV 208 G&C compiles cones of influence into the original FSM4FV 402A and into the optimized FSM4FV 402B in the interference stage 406. The compilation is based on the cones of influence states next_event logic synchronization. In the interference stage 406, the next_event logic of FSM verification properties 210 are updated to maximize FSM4FV states coverage and event logic of FSM drivers 212 are updated to optimize FV properties states reachable by fusion the embedded optimization techniques, or with a new optimization technique synthesized with LLM4FV G&C 400.

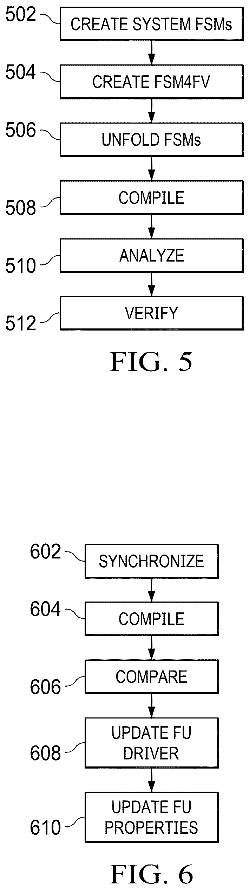

Referring now to FIGURE 5, there is illustrated a flow diagram of the operation of the LLM4FV G&C 208. For the interference stage 406, the LLM4SYSTEM 408 is used to create at step 502 system FSM 410 having next_event PSL operators. The training stage 404 creates FSM4FV 402 having embedded verification scalability options using CAD tools at 504. The system FSM 410 are unfolded at step 506 into various cones of influence 422 such that each property (property reduction, property decomposition, system decomposition, constant propagation and under approximations) have a cone of influence applied thereto. The unfolding is achieved by all the inputs, outputs and internal variables of the system that influence a specific property using the FV on system properties, the MBSE system interaction scenarios or formats 424 or the system interaction scenarios constructed by LLM4SYSTEM from the system FSM next_event representation. The property reduction 412, property decomposition 414, system decomposition 416, constant propagation 418 and under approximations 420 having a cone of influence applied thereto are compiled at step 508 by the LLM Contextual FSM4FV generator and compiler 400 into FSM4FV 402. The FSM4FV 402 comprises the original FSM4FV 402A in the training stage 404 and the optimized FSM4FV 402B in the interference stage 406. The system FSM 410 and FSM4FV 402B are analyzed at step 510 for the FV process optimization and coverage estimation. The FSM4FV 402 is verified at step 512 by the FV tool 102.

Referring now to FIGURE 6, there is illustrated the process flow for construction of the FSM4FV 402 by the generator and compiler 400. The next_event logic of the cones of influence states 422 are synchronized at step 602. The next_event logic is compiled at step 604 into FSM4FV 402. The FSM4FV 402 and the system FSM logic are compared at step 606 for FV process coverage estimation and analysis. The next_event logic of the FSM driver 212 is updated at step 608 to optimize the property states reachability. The next_event logic of the FSM verification properties 210 is updated at step 610 to maximize FSM4FV states coverage.

The system and method provide for efficient LLM translation of a natural language specification into correct CTL temporal properties in SVA or PSL, and the construction of a formal verification (model checking) environment. The proposed LLM4FV flow effectively combines LLM and FV into one flow using PSL low resource language advantages for system and FV environment description. The system uses an LLM double architecture configuration with design and FV roles separation.

Referring now back to FIGURE 4, as discussed previously, the FSM4FV 402 is constructed by the LLM contextual FSM4FV generator and compiler 400. The creation of the FSM4FV402 includes the construction of FSM structures for five different optimizations. These optimizations include training optimizations machines subject to verification scalability optimizations such as property reduction 412, property decomposition 414, system decomposition 416, constant propagation 418 and under approximations 420. The property reduction 412 reduces a complex property to a simpler one preserving its essential meaning. The property decomposition 414 breaks down a complex property into sub-properties. The system decomposition 416 decomposes a complex system into smaller interconnected components that are analyzed separately. Constant propagation 418 restricts the FV driver signals to be constant value. The under approximations 420 choose for the FV driver to set an input to a constant value for the rest of the run, although this compromises on coverage. These FSM structures 412-420 are constructed with a compilable next_event operator.

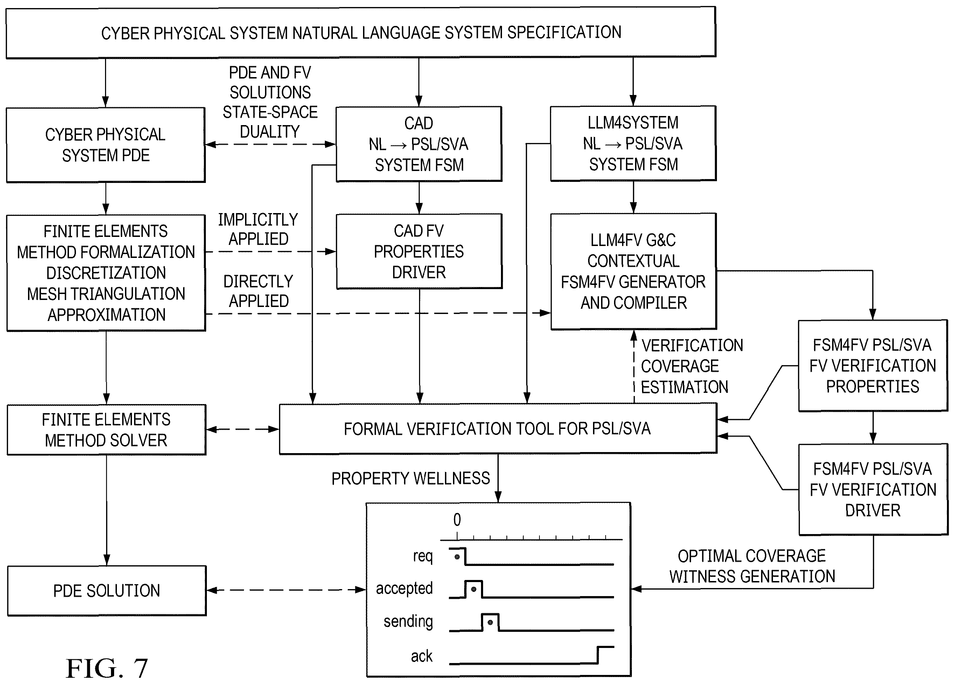

The quality of the optimization implementations is measured by a verification coverage estimation flow as shown in FIGURE 7.

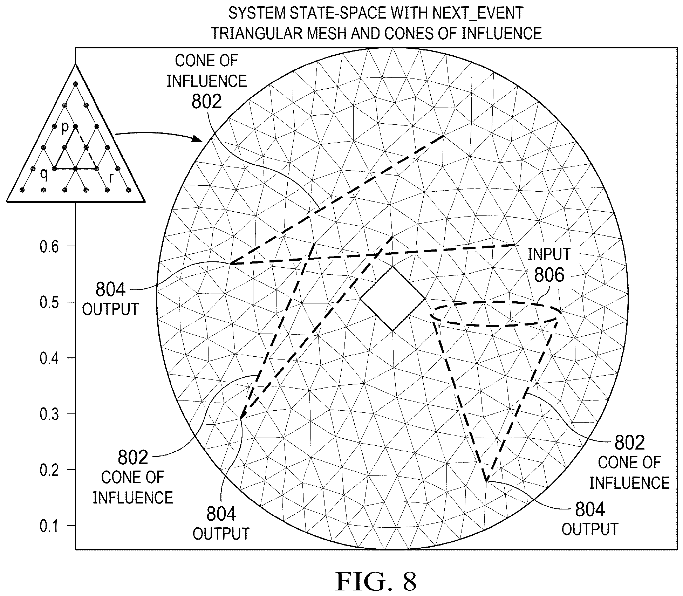

The process also provides for formal verification coverage estimation of FSMs constructed by LLM 208 from a specification 202 described with next_event operators. The topology, temporalities and importance of the FSM verification process states are modeled with a partial differential equation (PDE). The PDE solution states base is covered by a finite elements method (FEM) triangulation mesh of selected discretization (granulation) as shown in FIGURE 8.

FEM is a general numerical method for solving partial differential equations. To solve a problem, the FV subdivides a large system into smaller, simpler parts called finite elements. This is achieved by a particular space discretization in the space dimensions, which is implemented by the construction of a mesh of the object as shown in FIGURE 8. The mesh represents the numerical domain for the solution which has a finite number of points. The FEM formulation of a boundary value problem results in a system of algebraic equations. The FEM method approximates the unknown function over the domain. The simple equations that model these finite elements are assembled into a larger system of equations that models the entire problem. The FEM then approximates a solution by minimizing and associated error function via the calculation of variations. Typical workout by the FEM involves inviting the domain of the problem into a collection of sub-domains, with each sub-domain represented by a set of elements of equations to the original problem, systematically recombining offsets of element equations into a global system of equations for the final calculation. The global system of equations has known solution techniques that can be calculated from the initial values of the original problem to obtain a numerical answer.

The element equations are simple equations that locally approximate the original complex equations to be studied, where the original equations are often partial differential equations (PDE).

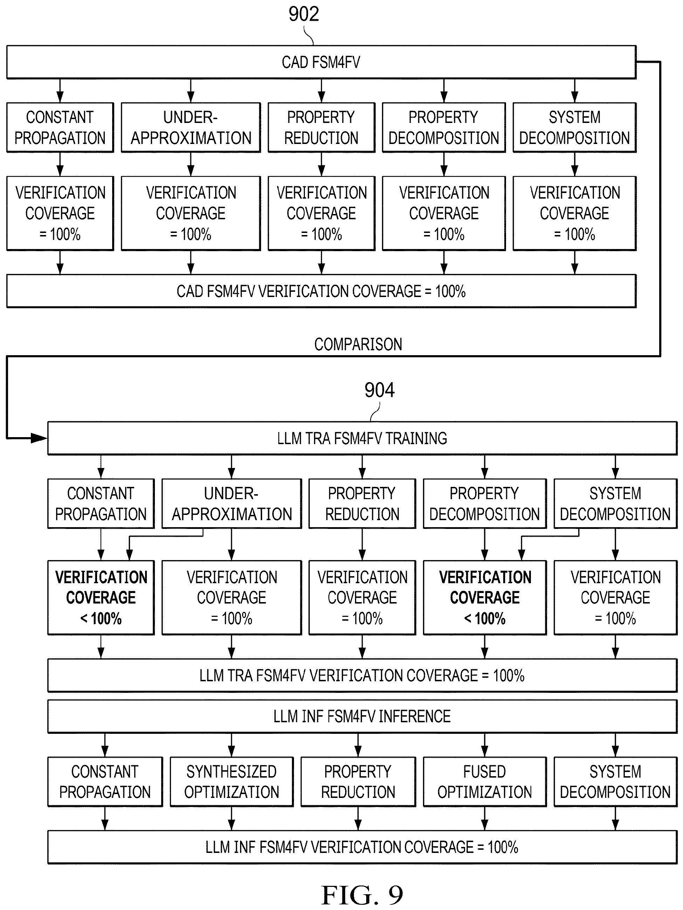

The CTL properties verification state base can be covered by the next_event triangulation mesh as shown in FIGURE 8. The coverage initial estimate is defined on the source CAD FSM4FV state machine 902 as shown in FIGURE 9. This estimation is used to train the LLM FSM4FV 404 for coverage estimation at the inference stage. A goal of training is to attain a maximal coverage under minimal perturbation (complexity) of system input state machines.

Functional verification coverage is a core performance metric for the verification process. Numerous ad hoc estimations leave verification with no feasible stopping criteria and is deemed incomplete. The FEM prompted coverage has the potential to prove that intended coverage point is reachable even under large magnitude of the FEM triangulation discretized state space, helping to derive a minimal set of verification properties and saving verification time and resources.

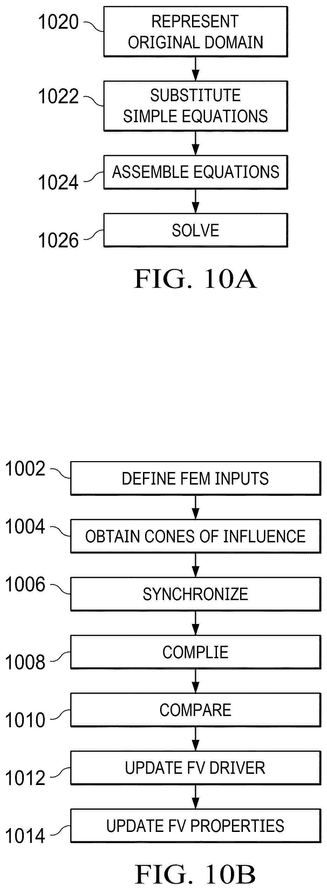

The process for implementing FEM is more particularly illustrated in FIGURE 10A. The original domain of the model is represented at step 1020 as a collection of elements. For each element, simple equations are substituted at 1022 for the original partial differential equations that locally approximate the original equations. Boundary conditions are also applied for each element. This can provide a linear set of equations for stationary linear problems, nonlinear equations for stationary problems where the coefficients depend on the solution or its gradient or a set of ordinary differential equations (ODEs) for time-dependent problems. The resulting equations and boundary conditions are assembled at step 1024 into a global system of equations that models the entire problem. The resulting system of algebraic equations or ODEs are solved at 1026 using linear solvers or numerical integration.

Referring now to FIGURE 10B, there is illustrated a flow diagram of the next_event granularity operations on the next_event structure. Initially, the verification scalability optimization is defined at step 1002 with FSM inputs perturbation logic. The representative cones of influence 802 are obtained at step 1004. Each cone of influence 802 represents the various outputs 804 that can be received responsive to inputs 806. The next_event logic of the states of the cones of influence 802 are synchronized at step 1006. The cones of influence next_event logic is compiled at step 1008 into the FSM4FV 904 using the LLM. The FSM4FV 904 is compared at step 1010 with the system FSM logic for FV process coverage estimation and analysis. The comparison results are used to update at step 1012 with the FEM next_event logic of the FV driver to optimize FV properties states reachability. Finally, at step 1014, the FV properties are updated with FEM next_event logic to maximize FSM4FV 904 states coverage.

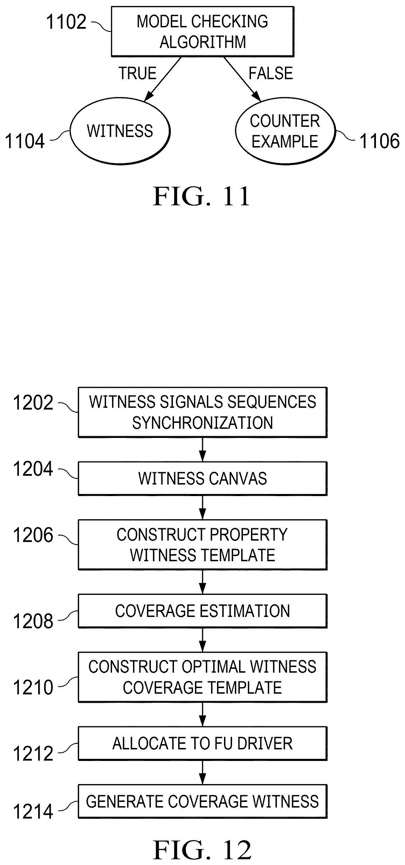

Referring now to FIGURE 11, there is illustrated the manner in which a model checking algorithm 1102 implemented within the FSM4FV verification driver 212 may be implemented to generate a witness response 1104 responsive to a true determination and a counterexample response 1106 responsive to a false determination. One of the most important advantages of model checking is its counterexample facility. The model checking algorithm implemented within the FSM4FV verification driver 212 either terminates with a true answer to provide the witness response 1104 or provides a counterexample response 1106 that shows why the formula checked by the algorithm is not satisfied. The true answer indicates that the model satisfies the specification while the false answer shows why the formula is not satisfied. The counterexamples 1106 and be essential in finding errors within complex designs of the FSM.

CTL model checking algorithms 1102 provides the ability to find counterexamples 1106 and witnesses 1104. When the model checking algorithm 1102 feature is enabled and the model checker determines that a formula with a universal path quantify or is false, it will find a computation path that demonstrates that the negation of the formula is true. Likewise, when the model checking algorithm 1102 determines that a formula with an essential path qualifier is true, the checker will find a computation path that demonstrates why the formula is true. A witness 1104/counterexample 1106 is a sequence of input values that satisfy/fail the property. Sometimes finding is counterexample can take most of the execution time of the FV tool 102. This can be because there is no easy solution to find the minimal finite witness, there is no easy solution to obtain a short as possible finite witness, or witnesses can be unnecessarily long when the number of reasonable states is large. Also, the generated counterexample is sometimes hard to read, and a more organized form may be helpful.

Referring now to FIGURE 12, there is illustrated a flow diagram of a method for the witness generation constructed by the LLM from the specification 202 described with next_event operators. Initially, the witness signal sequences are synchronized at step 1202 with the FSM4FV 212 next_event descriptions. The witness canvas (signal sequence) is organized at step 1204. From this information the property witness template is constructed at step 1206. The coverage estimation of the witness cone of influence is estimated at step 1208. The LLM4FV G&C 208 constructs at step 1210 the optimal coverage witness template. The LLM4FV G&C 208 allocates at step 1212 the optical witness signals in the FV driver. The coverage witness may then be generated at step 1214 from this information.

It may be advantageous to set forth definitions of certain words and phrases used throughout this patent document. The term "couple" and its derivatives refer to any direct or indirect communication between two or more components, whether or not those components are in physical contact with one another. The terms "include" and "comprise," as well as derivatives thereof, mean inclusion without limitation. The term "or" is inclusive, meaning and/or. The phrase "associated with," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, have a relationship to or with, or the like. The phrase "at least one of," when used with a list of items, means that different combinations of one or more of the listed items may be used, and only one item in the list may be needed. For example, "at least one of: A, B, and C" includes any of the following combinations: A, B, C, A and B, A and C, B and C, and A and B and C.

The description in the present disclosure should not be read as implying that any particular element, step, or function is an essential or critical element that must be included in the claim scope. The scope of patented subject matter is defined only by the allowed claims. Moreover, none of the claims invokes 35 U.S.C. § 112(f) with respect to any of the appended claims or claim elements unless the exact words "means for" or "step for" are explicitly used in the particular claim, followed by a participle phrase identifying a function. Use of terms such as (but not limited to) "mechanism," "module," "device," "unit," "component," "element," "member," "apparatus," "machine," "system," "processor," or "controller" within a claim is understood and intended to refer to structures known to those skilled in the relevant art, as further modified or enhanced by the features of the claims themselves, and is not intended to invoke 35 U.S.C. § 112(f).

While this disclosure has described certain embodiments and generally associated methods, alterations and permutations of these embodiments and methods will be apparent to those skilled in the art. Accordingly, the above description of example embodiments does not define or constrain this disclosure. Other changes, substitutions, and alterations are also possible without departing from the spirit and scope of this disclosure, as defined by the following claims.

## Claims

1. An apparatus for performing formal verification of a system design, comprising:
a first large language model (LLM) system configured to receive a natural language specification of the system design and generate a first description of the system design in a temporal logic language responsive to the natural language specification of the system design;
a second LLM system configured to receive the natural language specification of the system design and generate a second description of the system design in the temporal logic language responsive at least in part to the natural language specification of the system design;
a generator and compiler implemented within the second LLM system configured to generate finite state machines responsive to the second description of the system design in the temporal logic language, wherein the generated finite state machines each include a plurality of optimization properties, the optimization properties including property reduction, property decomposition, system decomposition, constant propagation and under approximation;
at least one finite state machine (FSM) generated by the generator and compiler configured to analyze operation of the system design using each of the at least one FSM including optimization properties, the optimization properties including property reduction, property decomposition, system decomposition, constant propagation and under approximation; and
a formal verification (FV) tool configured to determine whether the system design passes or fails responsive to the first description of the system design in the temporal logic language.

2. The apparatus of Claim 1, wherein the temporal logic language comprises standard property specification language (PSL).

3. The apparatus of Claim 1 or 2, wherein the first LLM and the second LLM are further configured to generate at least one PSL next_event operator responsive to the natural language specification of the system design.

4. The apparatus of Claim 1, 2 or 3, wherein the property decomposition breaks down a complex property into sub-properties.

5. The apparatus of any preceding Claim, wherein the system decomposition decomposes a complex system into smaller, interconnected components and analyzing the smaller, interconnected components separately.

6. The apparatus of any preceding Claim, wherein the constant propagation restricts an FV driver sum signal to a constant value.

7. The apparatus of any preceding Claim, wherein the under approximation sets an input value to an FV driver to a constant value for a rest of a run.

8. The apparatus of any preceding Claim, wherein the property reduction reduces a complex property to a simpler one preserving its essential meaning.

9. The apparatus of any preceding Claim, wherein the at least one FSM further comprises:
a first finite state machine (FSM) generated by the generator and compiler configured to generate verification properties for the system design responsive to the first description of the system design in the temporal logic language; and
a second FSM generated by the generator and compiler configured to generate verification drivers for the system design responsive to the first description of the system design in the temporal logic language and the verification properties for the system design.

10. A method for performing formal verification of a system design, comprising:
receiving a natural language specification of the system design at a first large language model (LLM) system;
generating a first description of the system design in a temporal logic language responsive to the natural language specification of the system design using the first LLM system;
receiving the natural language specification of the system design at a second LLM system;
generating a second description of the system design in the temporal logic language responsive at least in part to the natural language specification of the system design using the second LLM system;
generating finite state machines responsive to the second description of the system design in the temporal logic language using a generator and compiler implemented within the second LLM system, wherein the finite state machines each include a plurality of optimization properties, the optimization properties including property reduction, property decomposition, system decomposition, constant propagation and under approximation;
analyzing operation of the system design using at least one finite state machine (FSM) generated by the generator and compiler; and
determining whether the system design passes or fails responsive to the first description of the system design in the temporal logic language responsive to the analysis of the operation of the system design using the at least one FSM using a formal verification (FV) tool.

11. The method of Claim 10, wherein the step of generating further comprises generating the first description of the system design and the second description of the system design in standard property specification language (PSL).

12. The method of Claim 10 or 11, wherein the steps of generating further comprises generating at least one PSL next_event operator responsive to the natural language specification of the system design.

13. The method of Claim 10, 11 or 12, wherein the step of generating the finite state machines further comprises generating a finite state machine having a optimization characteristic of the property decomposition that breaks down a complex property into sub-properties; and/or
wherein the step of generating the finite state machines further comprises generating a finite state machine having a optimization characteristic of the system decomposition decomposes a complex system into smaller, interconnected components and analyzing the smaller, interconnected components separately; and/or
wherein the step of generating the finite state machines further comprises generating a finite state machine having a optimization characteristic of the constant propagation restricts an FV driver sum signal to a constant value; and/or
wherein the step of generating the finite state machines further comprises generating a finite state machine having a optimization characteristic of the under approximation sets an input value to an FV driver to a constant value for a rest of a run; and/or
wherein the step of generating the finite state machines further comprises generating a finite state machine having a optimization characteristic of the property reduction reduces a complex property to a simpler one preserving its essential meaning.

14. The method of any of Claims 10 to 13, wherein the at least one FSM further comprises:
generating verification properties for the system design responsive to the first description of the system design in the temporal logic language using a first finite state machine (FSM) generated by the generator and compiler; and
generating verification drivers for the system design responsive to the first description of the system design in the temporal logic language and the verification properties for the system design using a second FSM generated by the generator and compiler.

15. An apparatus for performing formal verification of a system design, comprising:
a first large language model (LLM) system configured to receive a natural language specification of the system design and generate a first description of the system design in a standard property specification language (PSL) responsive to the natural language specification of the system design;
a second LLM system configured to receive the natural language specification of the system design and generate a second description of the system design in the PSL responsive at least in part to the natural language specification of the system design;
a generator and compiler implemented within the second LLM system configured to generate finite state machines responsive to the second description of the system design in the PSL, wherein the generated finite state machines each include a plurality of optimization properties, the optimization properties including property reduction, property decomposition, system decomposition, constant propagation and under approximation;
a first finite state machine (FSM) including optimization properties generated by the generator and compiler configured to generate verification properties for the system design responsive to the first description of the system design in the PSL;
a second FSM including optimization properties generated by the generator and compiler configured to generate verification drivers for the system design responsive to the first description of the system design in the PSL and the verification properties for the system design;
wherein the optimization properties for the first FSM and the second FSM include property reduction, property decomposition, system decomposition, constant propagation and under approximation; and
a formal verification (FV) tool configured to determine whether the system design passes or fails responsive to the first description of the system design in the PSL.
